(19) Europäisches Patentamt
European Patent Office
Office européen des brevets

(11) **EP 3 420 782 B1**

(12) **EUROPÄISCHE PATENTSCHRIFT**

(45) Veröffentlichungstag und Bekanntmachung des Hinweises auf die Patenterteilung:
**04.09.2019 Patentblatt 2019/36**

(51) Int Cl.:
*H05B 6/10* *(2006.01)*      *H01L 21/687* *(2006.01)*
*F25B 21/02* *(2006.01)*      *H01L 21/67* *(2006.01)*

(21) Anmeldenummer: **17703340.4**

(22) Anmeldetag: **24.01.2017**

(86) Internationale Anmeldenummer:
**PCT/EP2017/051430**

(87) Internationale Veröffentlichungsnummer:
**WO 2017/144212 (31.08.2017 Gazette 2017/35)**

(54) **VORRICHTUNG UND VERFAHREN ZUR HALTERUNG, ROTATION SOWIE HEIZUNG UND/ODER KÜHLUNG EINES SUBSTRATS**

DEVICE AND METHOD FOR RETAINING, ROTATING AND HEATING AND/OR COOLING A SUBSTRATE

DISPOSITIF ET PROCÉDÉ POUR SUPPORTER, FAIRE TOURNER ET CHAUFFER ET/OU REFROIDIR UN SUBSTRAT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.02.2016 DE 102016103270**

(43) Veröffentlichungstag der Anmeldung:
**02.01.2019 Patentblatt 2019/01**

(73) Patentinhaber: **EV Group E. Thallner GmbH**
**4782 St. Florian am Inn (AT)**

(72) Erfinder:
• **WIESER, Thomas**
**84375 Kirchdorf (DE)**

• **TISCHLER, Michael**
**4975 Suben (AT)**

(74) Vertreter: **Schneider, Sascha et al**
**Becker & Müller**
**Patentanwälte**
**Turmstraße 22**
**40878 Ratingen (DE)**

(56) Entgegenhaltungen:
**EP-A1- 2 741 316      WO-A1-2015/145974**
**JP-A- 2001 003 172**

**Beschreibung**

Die Erfindung betrifft eine Vorrichtung und ein Verfahren zur Halterung, Rotation und Heizung eines Substrats gemäß den nebengeordneten Patentansprüchen.

In der Industrie werden unzählige Arten von Probenhaltern verwendet um Substrate, insbesondere Wafer, zu fixieren. Die Probenhalter müssen dabei unterschiedliche physikalische Aufgaben erfüllen. Einerseits dienen die Probenhalter der Fixierung des Substrats. Die Fixierung erfolgt häufig durch mechanische Klemmen, Vakuumbahnen, elektrostatische Ladungen, elektrische oder magnetische Felder oder adhäsive Oberflächen.

Die Druckschrift JP 2001 003127A offenbart eine Vorrichtung zur Halterung und Rotation eines Substrats. Die Druckschrift EP 2 741 316 A1 offenbart eine Bearbeitungsvorrichtung von Wafern, wobei Schichten auf der Oberfläche des Wafers aufgebracht werden.

Sehr viele Probenhalter erfüllen auch noch eine sekundäre Aufgabe wie beispielsweise Kühlen oder Heizen eines Substrats. Insbesondere Heizprobenhalter sind sehr gebräuchlich und in vielen unterschiedlichen Ausführungsformen vorhanden.

Probenhalter sind sehr oft auf die Anlagen, in denen sie verwendet werden, angepasst. Probenhalter für Schleuderbelackungsanlagen, die mit mehreren tausend Umdrehungen pro Minute rotieren, müssen hochsymmetrisch, leicht und flexibel konstruiert werden. Insbesondere müssen sie korrekt gewuchtet werden. Sehr oft werden gerade für derartige Probenhalter auch sekundäre Funktionalitäten wie Heizen verlangt.

Die Temperatur eines Heizprobenhalters wird direkt über ein Heizelement gesteuert, das über einen entsprechenden zugeführten Strom angesteuert werden muss. Das größte Problem besteht in der Übertragung des Stroms auf den sich drehenden Probenhalter. Die Stromübertragung zwischen zwei sich drehenden Teilen erfolgt normalerweise über Schleifkontakte. Schleifkontakte haben mehrere Nachteile. Erstens existiert zwischen dem Schleifkontakt und dem Abnehmer ein sehr hoher Verschleiß. Zweitens kann es durch die Kontaktierungsart zu Funkenschlag kommen. Sehr viele Flüssigkeiten, vor allem Lösungsmittel, sind relativ leicht entzündlich und besitzen einen relativ hohen Dampfdruck. Man muss daher immer davon ausgehen, dass sich in der Nähe eines Heizprobenhalters immer brennbare Gase befinden können, die zu einer Explosion führen können. Schleuderanlagen werden regelmäßig verwendet, um die Oberflächen von Substraten zu beschichten oder zu reinigen. Dabei kommen Chemikalien zum Einsatz, die brennbar sein können. Weisen diese Flüssigkeiten noch dazu hohe Dampfdrücke auf, kann schon ein kleiner Funke zur Explosion oder zum Brand führen.

Es ist daher die Aufgabe der vorliegenden Erfindung, eine Vorrichtung und ein Verfahren zur Halterung, Rotation und Heizung und/oder Kühlung eines Substrats zur Verfügung zu stellen, die die Nachteile des Stands der Technik nicht aufweisen und insbesondere möglichst verschleißfrei arbeiten sowie möglichst große Sicherheit bei der Verwendung bieten.

Die beschriebenen erfindungsgemäßen Ausführungsformen eignen sich für die Verwendung als Belacker oder Reiniger. Im ersten Fall werden sie auch Schleuderbelacker genannt.

Diese Aufgabe bzw. Aufgaben werden mit dem Gegenstand der nebengeordneten Patentansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Erfindungsgemäß vorgesehen ist eine Vorrichtung zur Halterung, Rotation sowie Heizung und/oder Kühlung eines Substrats, insbesondere Wafers, aufweisend:

　　1) einen Rotor, aufweisend:

　　　　a) mindestens eine Sekundärwicklung,
　　　　b) eine Substrathalterung mit einer Substrathalterungsoberfläche und Fixierelementen zur Fixierung des Substrats,
　　　　c) eine Drehwelle zur Rotation der Substrathalterung um eine Rotationsachse,
　　　　d) mindestens einen elektrischen Heizer zur Heizung und/oder einen Kühler zur Kühlung der Substrathalterungsoberfläche;
　　　　e) optional eine Steuerungselektronik zur Steuerung eines Stromes und/oder einer Spannung in der mindestens einen Primärwicklung

　　2) einen Stator, aufweisend:

　　　　a) mindestens eine Primärwicklung,
　　　　b) optional eine Steuerungselektronik zur Steuerung eines Stromes und/oder einer Spannung in der mindestens einen Primärwicklung,
　　　　c) einen ringförmigen Sockel, wobei die Drehwelle des Rotors zumindest teilweise innerhalb des Sockels angeordnet ist;

wobei die Vorrichtung derart ausgebildet ist, dass bei Rotation des Rotors durch die mindestens eine Primärwicklung ein Strom und/oder eine Spannung in der mindestens einen Sekundärwicklung induzierbar ist, wobei durch den in der mindestens einen Sekundärwicklung induzierten Strom und/oder Spannung der mindestens eine Heizer und/oder Kühler derart betreibbar ist, dass die Substrathalterungsoberfläche beheizbar und/oder kühlbar ist.

Die Vorrichtungen zum Kühlen des Substrats werden allgemein als Kühler bezeichnet Zur Kühlung des Substrats können insbesondere Peltierelemente verwendet werden. Erfindungsgemäß können Heizer und/oder Kühler im erfindungsgemäßen Probenhalter verbaut werden.

In einer bevorzugten Ausführungsform ist es vorgesehen, dass die mindestens eine Primärwicklung an einer Sockeloberfläche angeordnet ist. Dadurch ist vorteilhaft eine besonders gute Energieübertragung erreichbar.

In einer anderen bevorzugten Ausführungsform ist es vorgesehen, dass die mindestens eine Primärwicklung innerhalb des Sockels angeordnet ist. Dadurch ist vorteilhaft eine besonders bauraumsparende Ausbildung möglich.

In einer anderen bevorzugten Ausführungsform ist es vorgesehen, dass die mindestens eine Primärwicklung und die mindestens eine Sekundärwicklung als Flachspulen ausgebildet sind, bevorzugt als Spiralspulen, noch bevorzugter als archimedische Spiralspulen. Dadurch ist vorteilhaft eine besonders bauraumsparende Ausbildung möglich.

In einer anderen bevorzugten Ausführungsform ist es vorgesehen, dass die mindestens eine Primärwicklung und die mindestens eine Sekundärwicklung parallel zueinander angeordnet sind. Dadurch ist vorteilhaft eine besonders gute Energieübertragung möglich.

In einer anderen bevorzugten Ausführungsform ist es vorgesehen, dass die die mindestens eine Primärwicklung und die mindestens eine Sekundärwicklung in und/oder parallel zu einer Ebene angeordnet sind, wobei die Ebene senkrecht zur Rotationsachse angeordnet ist. Dadurch sind vorteilhaft eine besonders bauraumsparende Realisierung und eine gute Energieübertragung möglich.

In einer anderen bevorzugten Ausführungsform ist es vorgesehen, dass die mindestens eine Primärwicklung an einer der Substrathalterung zugewandten Sockeloberfläche des Sockels angeordnet ist. Dadurch ist vorteilhaft eine besonders gute Energieübertragung möglich.

In einer anderen bevorzugten Ausführungsform ist es vorgesehen, dass die mindestens eine Sekundärwicklung an einer dem Sockel zugewandten Rückseite der Substrathalterung angeordnet ist. Dadurch ist vorteilhaft eine besonders gute Energieübertragung möglich.

In einer anderen bevorzugten Ausführungsform ist es vorgesehen, dass die mindestens eine Primärwicklung und die mindestens eine Sekundärwicklung als Zylinderspulen ausgebildet sind. Dadurch ist vorteilhaft eine besonders gute Energieübertragung möglich.

In einer anderen bevorzugten Ausführungsform ist es vorgesehen, dass die mindestens eine Primärwicklung und die mindestens eine Sekundärwicklung konzentrisch zur Rotationsachse angeordnet sind. Dadurch ist vorteilhaft eine besonders gute Energieübertragung möglich.

In einer anderen bevorzugten Ausführungsform ist es vorgesehen, dass die mindestens eine Primärwicklung an einer der Drehwelle zugewandten Sockelinnenfläche des Sockels angeordnet ist und die mindestens eine Sekundärwicklung an einer der Sockelinnenfläche zugewandten Wellenoberfläche der Drehwelle angeordnet ist. Dadurch ist vorteilhaft eine besonders gute Energieübertragung möglich.

In einer anderen bevorzugten Ausführungsform ist es vorgesehen, dass die mindestens eine Primärwicklung und die mindestens eine Sekundärwicklung azentrisch zur Rotationsachse angeordnet sind. Dadurch ist vorteilhaft eine besonders gute Energieübertragung möglich.

In einer anderen bevorzugten Ausführungsform ist es vorgesehen, dass mindestens zwei Primärwicklungen innerhalb des Sockels und mindestens zwei Sekundärwicklungen innerhalb der Drehwelle angeordnet sind. Dadurch ist vorteilhaft eine besonders gute Energieübertragung möglich.

In einer anderen bevorzugten Ausführungsform ist es vorgesehen, dass die mindestens zwei Primärwicklungen und die mindestens zwei Sekundärwicklungen in einem gleichmäßigen Winkelabstand um die Rotationsachse herum angeordnet sind. Dadurch ist vorteilhaft eine besonders gute Energieübertragung möglich bei möglichst bauraumsparender Bauweise.

In einer anderen bevorzugten Ausführungsform weist die Vorrichtung eine Messeinrichtung auf zur Messung der Temperatur des Heizers, der Substrathalterung, der Substrathalterungsoberfläche und/oder des Substrats, sowie aufweisend eine Einrichtung zur Datenübertragung der gemessenen Temperatur des Heizers, der Substrathalterung, der Substrathalterungsoberfläche und/oder des Substrats vom Rotor auf den Stator, bevorzugt über die induktive Kopplung zwischen der mindestens einen Primärwicklung und der mindestens einen Sekundärwicklung. Dadurch ist vorteilhaft eine besonders gute Kontrolle der Temperatur möglich.

In einer anderen bevorzugten Ausführungsform ist es vorgesehen, dass der Rotor einen Identifikationschip aufweist, insbesondere RFID Chip, zur eindeutigen, und insbesondere vollautomatischen, Identifizierung des Rotors, wobei sich der Identifikationschip bevorzugt am Rand der Drehwelle befindet. Dadurch ist vorteilhaft eine besonders gute Austauschbarkeit des Rotors erreichbar.

In einer anderen bevorzugten Ausführungsform weist die Vorrichtung Spülmittel auf zur Umspülung des Rotors durch einen Gasstrom. Dadurch ist vorteilhaft ein besonders sicherer Betrieb der Vorrichtung möglich.

Außerdem ist erfindungsgemäß ein Verfahren vorgesehen zur Halterung, Rotierung sowie Heizung und/oder Kühlung eines Substrats, insbesondere Wafers, mit den folgenden Schritten, insbesondere mit einer Vorrichtung mit folgenden Merkmalen:

-     Halterung und Rotierung des Substrats durch einen Rotor, aufweisend eine Substrathalterung mit einer Substrathalterungsoberfläche und Fixierelementen zur Fixierung des Substrats, wobei die Substrathalterung mit dem Substrat über eine Drehwelle um eine Rotationsachse gedreht wird,

- Induktion eines Stromes, insbesondere aufgrund der Drehung des Rotors, in mindestens einer Sekundärwicklung des Rotors durch mindestens einestromdurchflossene Primärwicklung eines Stators,

- wobei durch den in der mindestens einen Sekundärwicklung induzierten Strom mindestens ein Heizer und/oder Kühler derart betrieben wird, dass die Substrathalterungsoberfläche und dadurch das Substrat beheizt und/oder gekühlt wird.

In einer bevorzugten Ausführungsform ist es vorgesehen, dass der Rotor durch einen Gasstrom, insbesondere einen Inertgasstrom, umspült wird, wobei bevorzugt außen anliegende elektrische Bauteile, insbesondere ein primärseitiges Kondensatorteil und ein sekundärseitiges Kondensatorteil, umspült werden, wobei bevorzugt zwischen dem Rotor und dem Stator ein Überdruck aufgebaut wird, der größer ist als ein Umgebungsdruck. Dadurch kann vorteilhaft ein besonders sicherer Betrieb gewährleistet werden.

Im Folgenden wird statorseitig auch mit primärseitig und rotorseitig auch mit sekundärseitig bezeichnet. Eine Wicklung wird im Folgenden auch als Spule bezeichnet. Die Substrathalterung wird im Folgenden auch als Probenhalter bezeichnet.

Der Kern der Erfindung besteht insbesondere in der Übertragung der elektrischen Leistung bzw. der Spannung und/oder des Stroms von einem Stator auf einen Rotor durch elektromagnetische Induktion. Des Weiteren werden mehrere Möglichkeiten zur kontaktlosen Messsignalübertragung offenbart.

Durch die erfindungsgemäße Ausführungsform werden die mechanischen Komponenten von den elektrischen Komponenten getrennt. Es kann vor allem auf Schleifkontakte verzichtet werden, die, insbesondere in einer brandfördernden Atmosphäre, ein erhebliches Sicherheitsrisiko durch Funkenbildung darstellen.

Die Erfindung beschreibt insbesondere ein Verfahren und eine Anlage zur elektro-mechanisch entkoppelten Stromübertragung durch elektromagnetische Induktion sowie eine elektro-mechanisch entkoppelte Messung der Temperatur durch induktive, kapazitive oder elektromagnetische Verfahren und eine daraus mögliche Regelung.

**Die elektromagnetische Induktion**

Der Erfindung liegt bei der Leistungs-, Spannungs- bzw. Stromübertragung für die Heizelemente das Grundprinzip einer induktiven Kopplung zugrunde. Die induktive Kopplung kann auch als Transformator verstanden werden. Der Transformator besteht aus einer Primär- und einer Sekundärseite. Die Primär- und die Sekundärseite besitzen jeweils mindestens eine Leiterschleife, insbesondere eine Spule. Im weiteren Verlauf des Textes werden Leiterschleife und Spule als Synonyme verwendet. Die Anordnung und Anzahl der Spulen kann sich in den erfindungsgemäßen Ausführungsformen unterscheiden.

Die Spulen besitzen insbesondere genau 1 Wicklung, vorzugsweise mehr als 5 Wicklungen, noch bevorzugter mehr als 10 Wicklungen, am bevorzugtesten mehr als 100 Wicklungen, am allerbevorzugtesten mehr als 1000 Wicklungen. In besonders bevorzugten Ausführungsformen werden Spulen mit 5 bis 100 Wicklungen verwendet.

Die Primärseite ist Teil des Stators. Die Sekundärseite ist Teil des Rotors. Der Stator besteht aus der Menge aller Maschinenbauteile, die statisch sind. Der Rotor besteht aus der Menge aller Maschinenbauteile, die als Ganzes rotieren. Rotor und Stator sind voneinander vollständig elektro-mechanisch entkoppelt. Unter einer elektro-mechanischen Entkopplung versteht man, dass die Stromübertragung von einem ersten mechanischen Bauteil, insbesondere dem Stator, auf das zweite mechanische Bauteil, insbesondere dem Rotor, nicht mittels Stromleitungen und/oder Schleifkontakten, sondern über elektromagnetische Induktion erfolgt. Im Gegensatz zum Stand der Technik erfolgt die Leistungsübertragung also ausschließlich mittels elektromagnetischer Induktion.

Nach dem Faraday'schen Induktionsgesetz wird über einer Leiterschleife immer dann eine Spannung induziert, wenn sich der magnetische Fluss durch die Leiterschleife zeitlich ändert. Anschaulich kann das dadurch beschrieben werden, dass sich die Anzahl der magnetischen Feldlinien pro Einheitsfläche, d.h. die Feldliniendichte, durch die Leiterschleife zeitlich ändert. Diese Änderung kann durch unterschiedliche physikalische Effekte erzeugt werden.

Denkbar ist eine Änderung der Feldliniendichte durch eine zeitliche Veränderung des Stroms, der das magnetische Feld erzeugt. Dabei ist es nur von Relevanz, dass sich die Stromstärke, die mit der Stärke des Magnetfeldes korreliert ist, ändert. Daher ist die Verwendung von gepulstem oder oszillierendem Gleichstrom genauso möglich, wie die Verwendung von Wechselstrom. Der Wechselstrom zeichnet sich durch eine Änderung der Stromrichtung und damit durch eine sich wiederholende Umpolung des Magnetfeldes aus, während gepulster oder oszillierender Gleichstrom niemals sein Vorzeichen ändert, aber die Feldliniendichte und damit der magnetische Fluss sich dennoch ändert.

Eine weitere Möglichkeit stellt die rein mechanische Relativbewegung zwischen dem erzeugten magnetischen Feld und der abnehmenden Leiterschleife dar. Die Leiterschleife durchläuft hierbei Orte mit hohen und mit niedrigen Feldliniendichten. Durch diese Relativbewegung kommt es ebenfalls zu einer zeitlichen Änderung des magnetischen Flusses. Analoge Überlegungen gelten für die Betrachtungsweise, bei der nicht die zeitliche Änderung des magnetischen Flusses, sondern die zeitliche Änderung der magnetischen Induktion bzw. der magnetischen Feldstärke betrachtet wird. In den erfindungsgemäßen Ausführungsformen handelt es sich bei der Relativbewegung ausschließlich um eine Rotationsbewegung des Rotors in Bezug zum Stator. In diesem Fall ist es von Bedeutung, dass die Sekundärspule während einer Rotationsbewegung ein asymmetrisches magnetisches Feld der Primärspule durchläuft.

In einer weiteren Möglichkeit werden die beiden obigen Effekte miteinander kombiniert.

In einer beispielhaften erfindungsgemäßen Ausführungsform erfolgt die Übertragung der elektrischen Leistung durch die Verwendung eines oszillierenden Gleichstroms, vorzugsweise aber durch einen angelegten Wechselstrom, an der Primärseite. Primär- und sekundärseitig werden Flachspulen verwendet. Da das primärseitig angelegte magnetische Feld nicht radialsymmetrisch um eine Achse Ap der primärseitigen Flachspule ist, kann sekundärseitig eine Spannung auch durch reine Rotation erzeugt werden, ohne einen oszillierenden Gleichstrom oder Wechselstrom zu verwenden. Die Flachspulen sind insbesondere als Spiralen, noch bevorzugter als Archimedische Spiralen, ausgeführt. Die Flachspule auf der Primärseite kann im oder auf dem Stator montiert sein. Die Flachspule auf der Sekundärseite kann im oder auf dem Rotor, insbesondere im Probenhalter, montiert sein.

In einer anderen beispielhaften erfindungsgemäßen Ausführungsform erfolgt die Übertragung der elektrischen Leistung durch die Verwendung eines oszillierenden Gleichstroms, vorzugsweise aber durch einen angelegten Wechselstrom, an einer primärseitigen Spule. Da in dieser erfindungsgemäßen Ausführungsform die Achse Ap der Primärspule und die Achse As der Sekundärspule miteinander koinzidieren und das erzeugte primärseitige Magnetfeld radialsymmetrisch um die Spulenachse Ap ist, kann die Änderung des magnetischen Flusses durch die Sekundärspule niemals durch eine reine Relativbewegung, sondern ausschließlich durch einen oszillierenden Gleichstrom, vorzugsweise aber durch einen angelegten Wechselstrom, erzeugt werden.

In einer anderen beispielhaften erfindungsgemäßen Ausführungsform erfolgt die Übertragung der elektrischen Leistung durch zwei zueinander asymmetrisch gelagerte und zueinander rotierende Spulen. Das primärseitig angelegte magnetische Feld ist zwar symmetrisch um die Achse Ap, allerdings koinzidieren die Achsen Ap und As nicht miteinander. Damit ist bei einer Relativbewegung zwischen Stator und Rotor das magnetische Feld aus der Sicht der Sekundärspule nicht konstant. Die Sekundärspule durchläuft quasi Bereiche mit hoher und Bereiche mit niedriger Feldliniendichte, was wiederum zu einer Induktion einer sekundärseitigen Spannung führen kann. In dieser speziellen Ausführungsform ist darauf zu achten, dass die Anzahl der Spulen auf der Primärseite nicht soweit erhöht werden, dass sie durch Überlagerung der magnetischen Felder ein symmetrisches Magnetfeld erzeugen, welches nicht mehr zur Induktion einer sekundärseitigen Spannung rein durch Rotationsbewegung führen kann. Unabhängig davon kann auch in dieser erfindungsgemäßen Ausführungsform in der Sekundärspule immer eine Spannung durch die Verwendung eines oszillierenden Gleichstroms, vorzugsweise aber durch einen angelegten Wechselstrom, erzeugt werden.

Die Frequenz des verwendeten Wechselfeldes liegt zwischen 0 Hz und 100 kHz, vorzugsweise zwischen 5 Hz und 75 kHz, noch bevorzugter zwischen 10 Hz und 50 kHz, am bevorzugtesten zwischen 15 Hz und 25 kHz, am allerbevorzugtesten zwischen 20 Hz und 20 kHz.

An der Primärwicklung liegen Spannungen zwischen 0 Volt und 1000 Volt, vorzugsweise zwischen 5 Volt und 750 Volt, noch bevorzugter zwischen 10 Volt und 600 Volt, am bevorzugtesten zwischen 15 Volt und 500 Volt, am allerbevorzugtesten zwischen 24 Volt und 400 Volt an.

Vorzugsweise werden die übertragene Sekundärspannung und damit die übertragene Leistung während der Drehung, insbesondere auch während der Beschleunigungsphasen, des Probenhalters konstant gehalten. Bei den Ausführungsformen, bei denen ein asymmetrisches magnetisches Feld auf der Primärseite aufgebaut wird, wird die induzierte Spannung auf der Sekundärseite explizit von der Drehzahl des Probenhalters abhängen. Um die sekundärseitige Spannung, und damit die Leistung, konstant zu halten, muss primärseitig auf alle Fälle ein, insbesondere kontinuierlich regelbares, Wechselfeld verwendet werden. Die für die erfindungsgemäßen Ausführungsformen erwähnte Verwendung von Gleichstrom auf der Primärseite erlaubt damit keine konstante Leistungsübertragung.

Abschließend wird daher festgehalten, dass in allen erfindungsgemäßen Ausführungsformen die Verwendung von Wechselstrom immer die bevorzugte Wahl ist.

**Der Probenhalter**

Der Probenhalter ist mit Vorzug so konstruiert, dass er die durch den/die Heizer erzeugte Wärmemenge vorwiegend in Richtung des auf ihm fixierten Substrats abgibt.

Der Probenhalter ist damit an seiner Unterseite und seiner Peripherie vorzugsweise isolierend konstruiert. Die Isolierung erfolgt vorwiegend durch Materialien mit einer sehr geringen Wärmeleitfähigkeit. Vorzugsweise werden auch Vakuumkammern eingebaut, die einen thermischen Fluss weiter erschweren. Die Wärmeleitfähigkeit in Richtung der Unterseite und der Peripherie ist kleiner als 1 W/(m*K), vorzugsweise kleiner als 0.05 W/(m*K), noch bevorzugter kleiner als 0.025 W/(m*K), am bevorzugtesten kleiner als 0.01 W/(m*K).

Der Probenhalter ist in Richtung des Substrats vorzugsweise so konstruiert, dass seine Wärmeleitfähigkeit maximal ist. Die hohe Wärmeleitfähigkeit erfolgt vorwiegend durch die Verwendung von Werkstoffen mit einer hohen Wärmeleitfähigkeit. Die Wärmeleitfähigkeit in Richtung des Substrats liegt zwischen 0.1 W/(m*K) und 5000 W/(m*K), vorzugsweise zwischen 1 W/(m*K) und 2500 W/(m*K), noch bevorzugter zwischen 10 W/(m*K) und 1000 W/(m*K), am bevorzugtesten zwischen 100 W/(m*K) und 450 W/(m*K).

Der Probenhalter ist vorzugsweise so konstruiert, dass sein Deviationsmoment um die Drehachse null ist. Sollte der Probenhalter ein Deviationsmoment besitzen, das von null verschieden ist, so werden Gewichte verwendet um die Unwucht zu beseitigen und das Deviationsmoment zu entfernen.

Der Probenhalter verfügt über Fixierungen. Die Fixierungen dienen der Fixierung der Substrate. Bei den Fixierungen kann es sich um

- Mechanische Fixierungen, insbesondere

  ○ Klemmen

- Vakuumfixierungen, insbesondere mit

  ○ einzeln ansteuerbare Vakuumbahnen
  ○ miteinander verbundenen Vakuumbahnen

- Elektrische Fixierungen, insbesondere
  ○ Elektrostatische Fixierungen
- Magnetische Fixierungen
- Adhäsive Fixierungen, insbesondere

  ○ Gel-Pak Fixierungen
  ○ Fixierungen mit adhäsiven, insbesondere ansteuerbaren, Oberflächen handeln.

Die Fixierungen sind insbesondere elektronisch ansteuerbar. Die Vakuumfixierung ist die bevorzugte Fixierungsart. Die Vakuumfixierung besteht vorzugsweise aus mehreren Vakuumbahnen, die an der Oberfläche des Probenhalters austreten. Die Vakuumbahnen sind vorzugsweise einzeln ansteuerbar. In einer technisch eher realisierbaren Anwendung sind einige Vakuumbahnen zu Vakuumbahnsegmenten vereint, die einzeln ansteuerbar, daher evakuiert oder geflutet werden können. Jedes Vakuumsegment ist allerdings unabhängig von den anderen Vakuumsegmenten. Damit erhält man die Möglichkeit des Aufbaus einzeln ansteuerbarer Vakuumsegmente. Die Vakuumsegmente sind vorzugsweise ringförmig konstruiert. Dadurch wird eine gezielte, radialsymmetrische, insbesondere von Innen nach Außen durchgeführte Fixierung und/oder Loslösung eines Substrats vom Probenhalter ermöglicht.

Bei den Substraten handelt es sich mit Vorzug um Wafer. Die Wafer sind genormte Substrate mit wohldefinierten, standardisierten Durchmessern. Die Substrate können allerdings im Allgemeinen jede beliebige Form besitzen. Die Durchmesser der Substrate können im Allgemeinen jede beliebige Größe annehmen, besitzen aber meistens eine der genormten Durchmesser von 1 Zoll, 2 Zoll, 3 Zoll, 4 Zoll, 5 Zoll, 6 Zoll, 8 Zoll, 12 Zoll und 18 Zoll bzw. 25.4 mm, 50.8 mm, 76.2 mm, 100 mm, 125 mm, 150 mm, 200 mm, 300 mm, 450 mm.

Denkbar ist auch die Verwendung quadratischer Substrate.

Im weiteren Verlauf der Beschreibung wird allgemein von Substraten gesprochen. Insbesondere beziehen sich die erfindungsgemäßen Ausführungsformen allerdings vorwiegend auf Wafer.

Die Rotationsfrequenz wird in Runden pro Minute (engl.: rounds per minute, rpm) angegeben. Der Probenhalter kann mit Frequenzen von mehr als 0 rpm, vorzugsweise mehr als 10 rpm, noch bevorzugter mehr als 100 rpm, am bevorzugtesten mehr als 1000 rpm, am allerbevorzugtesten mehr als 3000 rpm rotieren.

Die Beschleunigung wird in rpm pro Sekunde (engl.: rounds per minute per second, rpm/s) angegeben. Der Probenhalter kann mit mehr als 0 rpm/s, vorzugsweise mehr als 100 rpm/s, noch bevorzugter mehr als 1000 rpm/s, am bevorzugtesten mehr als 10000 rpm/s, am allerbevorzugtesten mehr als 40000 rpm/s beschleunigen.

**Der Heizer**

Bei dem Heizer handelt es sich um einen ansteuerbaren und regulierbaren Heizer. Der Heizer kann auf mehrere Arten angesteuert werden.

In einer erfindungsgemäßen Ausführungsform sind der Heizer und die Spulen der Sekundärseite direkt miteinander verbunden, sodass nur die Größe der induzierten Spannung den Strom regelt, der für die Heizleistung verantwortlich ist.

In einer anderen erfindungsgemäßen Ausführungsform befindet sich eine Steuerungselektronik in der Sekundärseite. Der an der Sekundärseite erzeugte Strom wird durch eine Steuerungselektronik geregelt. Damit sind eine gezielte Beeinflussung des Stroms zum Heizer und damit eine Steuerung der Heizleistung möglich.

In einer weiteren erfindungsgemäßen Erweiterung können mehrere Heizer im Probenhalter verteilt sein. Die Heizer sind dann entsprechend alle mit den Leitungen der Sekundärseite verbunden. Durch die Verwendung mehrere, insbesondere symmetrisch angeordneter, Heizer kann ein Temperaturprofil gezielt eingestellt werden. Es befinden sich mehr als 1, bevorzugt mehr als 3, bevorzugter mehr als 5, noch bevorzugter mehr als 10, am bevorzugtesten mehr als 25, am allerbevorzugtesten mehr als 100 Heizer im Probenhalter. Je größer die Anzahl der Heizer, desto komplizierter wird die Elektronik zum Ansteuern der Heizer ausfallen. Die Heizer können symmetrisch oder asymmetrisch im Substratprobenhalter verteilt sein. In einer bevorzugten Ausführungsform sind die Heizer so verteilt, dass sie die Einstellung eines Temperaturgradienten erlauben. Besonders bevorzugt sind dabei Temperaturgradienten mit einem Temperaturmaximum am Rand und einem Temperaturminimum im Zentrum. Das kann durch eine höhere Heizerdichte am Rand bewerkstelligt werden. Noch bevorzugter ist allerdings eine Heizerverteilung, die eine homogene Heizerdichte zur Folge hat. Durch Steuerungssoftware und gezielte Ansteuerung der Heizer können die Temperaturprofile dann über eine Software eingestellt und optimaler kontrolliert werden.

Als Heizer kommen in Betracht:

- Keramikheizer,
- Dünnschichtheizer,
- Infrarotheizer.

Der Heizer kann den Probenhalter, insbesondere das Substrat, auf Temperaturen aufheizen zwischen Raumtemperatur und 400°C, bevorzugt zwischen 50°C und 300°C, noch bevorzugter zwischen 100°C und 200°C.

Durch die erfindungsgemäße Leistungsübertragung durch induktive Kopplung können auch sehr hohe Heizraten erzeugt werden. Die Heizrate liegt zwischen 0°C/min und 60°C/min, bevorzugt zwischen 0°C/min und 50°C/min, bevorzugter zwischen 0°C/min und 25°C/min, noch bevorzugter zwischen 0°C/min und 15°C/min, am bevorzugtesten zwischen 0°C/min und 10°C/min, am allerbevorzugtesten zwischen 0°C/min und 5°C/min.

Die von den Heizern erzeugte Temperaturgleichmäßigkeit ist besser als 10%, vorzugsweise besser als 7.5%, noch bevorzugter besser als 5%, am bevorzugtesten besser als 2.5%, am allerbevorzugtesten besser als 1%. Das bedeutet, dass die Temperatur als Funktion des Ortes im optimalen Fall um weniger als 1% um den gewünschten Temperaturwert schwankt, sofern eine homogene Temperaturverteilung erwünscht ist. Durch die Verwendung mehrere Heizer, einer entsprechenden Elektronik und entsprechenden Reglern können allerdings immer gewollte Temperaturgradienten erzeugt werden.

Die Temperaturgenauigkeit ist besser als 10%, vorzugsweise besser als 7.5%, noch bevorzugter besser als 5%, am bevorzugtesten besser als 2.5%, am allerbevorzugtesten besser als 1%. Unter Temperaturgenauigkeit versteht man die Genauigkeit, mit der ein Temperaturwert an einer Position eingestellt werden kann. Die Genauigkeit ist die Abweichung des Mittelwertes vom Sollwert.

Die übertragen Leistung der erfindungsgemäßen Ausführungsform liegt zwischen 0 Watt und 2000 Watt, vorzugsweise zwischen 50 Watt und 1500 Watt, noch bevorzugter zwischen 100 Watt und 1000 Watt, am bevorzugtesten zwischen 150 Watt und 800 Watt, am allerbevorzugtesten zwischen 200 Watt und 600 Watt. Typische Leistungen um einen 200 mm Wafer zu heizen liegen im Bereich von 200 Watt.

## Die Messung

Eine weitere Aufgabe der erfindungsgemäßen Ausführungsformen besteht darin, Messsignale, insbesondere die Temperatur im Probenhalter, noch bevorzugter die Temperatur am Substrat, vom Rotor auf den Stator zu übertragen.

In einer bevorzugten erfindungsgemäßen Ausführungsform wird die Temperatur indirekt über die thermische Dehnung des Heizers ermittelt. Diese thermische Dehnung führt zu einer Änderung des elektrischen Widerstands. Der elektrische Widerstand ist direkt proportional zum spezifischen elektrischen Widerstand und verkehrt proportional zur Länge des Leiters durch den der Strom fließt. Des Weiteren hängt der elektrische Widerstand noch direkt vom Querschnitt dieses Leiters ab. In der Gleichstromtechnik kann man folgenden Zusammenhang zwischen dem Widerstand einerseits und dem spezifischen Widerstand, dem Querschnitt und der Länge des Leiters andererseits finden:

$$R = \rho \frac{A}{L}$$

Durch die Induktion eines Stroms auf der Sekundärseite fließt ein Strom durch den Heizer. Der Heizer erwärmt seine Umgebung und wird dabei auch selbst erwärmt. Durch die erhöhte Temperatur dehnt sich der Heizer aus und ändert seinen Widerstand. Diese Widerstandsänderung kann nun sekundärseitig, vorzugsweise aber sogar primärseitig, gemessen werden. Bei einer sekundärseitigen Messung wird die Widerstandsänderung vorzugsweise durch eine Elektronik ermittelt. Ein entsprechend erzeugtes Messsignal wird von der Elektronik erzeugt und über die erfindungsgemäßen Methoden kontaktlos übertragen.

In einer ganz besonders bevorzugten erfindungsgemäßen Ausführungsform wird die Temperatur indirekt über die Impedanz auf der Sekundärseite vermessen. Unter der Impedanz versteht man den Wechselstromwiderstand. Sie kann durch die Spannung, die an einem Verbraucher abfällt und der aufgenommenen Stromstärke berechnet werden. Die Stromstärke I, die durch einen Verbraucher fließt, an die Spannung U abfällt, hängt erst einmal von dessen Widerstand ab:

$$I = \frac{U}{R}$$

Andererseits kann aber auch der Widerstand ermittelt werden, wenn man Spannung und Strom misst:

$$R = \frac{U}{I}$$

In der Wechselstromtechnik verwendet man die zeitlich veränderlichen Größen U(t) und I(t) und ermittelt die Impedanz, d.h. den Wechselstromwiderstand durch:

$$\underline{Z} = \frac{\underline{U}(t)}{\underline{I}(t)}$$

Die Impedanz ist eine vektorielle Größe, die in einem Polarkoordinatensystem entsprechend einfach abgebildet werden kann. Durch die Vermessung der zeitlich veränderlichen Wechselspannung U(t) und des zeitlich veränderlichen Stroms I(t), der sich bei Temperaturerhöhung auf der Sekundärseite verändern muss, da sich der Widerstand verändert, kann auf die Temperatur rückgeschlossen werden. Da es sich bei dieser erfindungsgemäßen Methode um eine indirekte Temperaturvermessung handelt, wird vorzugsweise eine Kalibrierungen des Systems durchgeführt. Dabei korreliert man am besten die gemessene Impedanz mit einer, durch ein externes, insbesondere sehr genaues, Temperaturmessgerät gemessenen Temperatur. Dadurch wird es in einem erfindungsgemäßen Steuerungsvorgang möglich, durch die Vermessung der Impedanz auf die Temperatur zurückzuschließen. Die erfindungsgemäße induktive Kopplung überträgt also gleichzeitig das Messsignal. Man benötigt in dieser erfindungsgemäßen Ausführungsform keinen eigenen Messkreis.

In einer anderen erfindungsgemäßen Ausführungsform wird das Messsignal über eine kapazitive Kopplung vom Rotor auf den Stator ausgekoppelt. Das Messsignal wird von mindestens einem Sensor, insbesondere einem Thermoelement, aufgenommen. Vorzugsweise wird das Signal bereits in einer Elektronik, die sich im Probenhalter befindet, entsprechend verarbeitet. Dazu verfügt die Vorrichtung über statorseitige Kondensatorteile und rotorseitige Kondensatorteile.

In einer anderen erfindungsgemäßen Ausführungsform wird das Messsignal über eine Strahlungsmessung, insbesondere Infrarotmessung, vom Rotor auf den Stator übertragen. Das Messsignal wird von mindestens einem Sensor, insbesondere einem Thermoelement, aufgenommen. Vorzugsweise wird das Signal bereits in einer Elektronik, die sich im Probenhalter befindet, entsprechend verarbeitet. Am Rotor befindet sich ein entsprechender Sender, insbesondere Infrarotsender, am Stator ein entsprechender Empfänger, insbesondere Infrarotempfänger. Grundsätzlich können elektromagnetische Strahlen im Wellenlängenbereich zwischen 2000 nm und 1000 $\mu$m, vorzugsweise zwischen 1500 nm und 1000 $\mu$m, noch bevorzugter zwischen 1000 nm und 1000 $\mu$m, am bevorzugtesten zwischen 780 nm und 1000 $\mu$m verwendet werden.

In einer anderen erfindungsgemäßen Ausführungsform erfolgt die Übertragung des Messsignals über Funk. Dazu sind entsprechende Funksender und Empfänger notwendig. Dazu verfügt die Vorrichtung über statorseitige Funkempfänger und rotorseitige Funksender.

Insbesondere muss das Funkmodul auf der Rotorseite mit entsprechender Elektronik und konstanter Spannung bzw. konstantem Strom betrieben werden. Im Allgemeinen gilt, dass sich die Elektronik im Rotor, im Stator oder einem von der erfindungsgemäßen Ausführungsform getrennt aufgestellten Computer befinden kann. Der Wellenlängenbereich liegt oberhalb der Infrarotwellenlänge. Die Wellenlänge liegt zwischen 1mm und 10km, vorzugsweise zwischen 1cm und 1km, noch bevorzugter zwischen 1dm und 100m, am bevorzugtesten zwischen 1dm und 50m, am allerbevorzugtesten zwischen 1dm und 25m.

**Die Regelung**

In einer anderen erfindungsgemäßen Ausführungsform existiert eine Regelung zwischen der induktiven Kopplung und dem Messsystem. Die Regelung ermittelt dabei kontinuierlich die Messgrößen, insbesondere die Temperatur bzw. den Temperaturverlauf, und regelt abhängig vom jeweiligen vorgegebenen Sollwert die Temperatur. Vorzugsweise werden PID Kontroller verwendet. Bei den PID Kontrollern kann es sich um Software und/oder Hardware PID Kontroller handeln. Die Umsetzung der Regelung erfolgt vorzugsweise durch einen Soft-Regler, welcher auf einem SPS-System implementiert wird. Die Ausgangsstellgröße dieses Reglers beeinflusst die Amplitude der Primärspannung des Heizers.

Um die übertragene Leistung konstant zu halten, was einer bevorzugten Ausführungsform entspricht, muss zur adaptiven Regelung des Leistungskreises der Drehzahlwert des Probenhalters als Eingangsgröße zur Verfügung stehen.

**Austauschbarkeit**

Durch eine elektro-mechanische Entkopplung des Rotors vom Stator können unterschiedliche Rotoren sehr schnell ausgetauscht werden. Denkbar ist beispielsweise, dass die Rotoren Wellen mit einer Nut an ihrer Unterseite besitzen, in die ein Mitnehmer einer Antriebswelle eingreift, um das Moment zu übertragen. Derartige Konstruktionen sind einfach zu konstruieren und zu warten. Durch die erfindungsgemäße elektro-mechanische Entkopplung des Stators vom Rotor und den Verzicht auf Schleifkontakte, kann der Austausch völlig mühelos, insbesondere sogar automatisch durch einen Roboter erfolgen.

Die Rotoren der erfindungsgemäßen Ausführungsformen werden vorzugsweise einzeln kalibriert. Nachdem einer der Rotoren ausgetauscht wurde, muss mit der Software entweder eine neue Kalibrierung durchgeführt oder zumindest eine alte Kalibrierung geladen werden. Eine weitere erfindungsgemäße Erweiterung stellt die automatische Identifizierung des Rotors, insbesondere mit Hilfe eines RFID Chips, dar. Der Rotor wird eingesetzt, automatisch erkannt und das entsprechende Kalibrierungsprogramm wird in der verwendeten Software aktiviert. Damit wird eine eindeutige Zuordnung des Rotors zur korrekten Kalibrierung gewährleistet.

**Verkapselung**

Da sich sowohl das Heizelement als auch Elemente zur Messsignalübertragung innerhalb einer Kammer befinden, erfüllen die erfindungsgemäßen Ausführungsformen vorzugsweise gewisse Brandschutzanforderungen. Die wichtigsten Brandschutzanforderungen sind

•    Abdichtung des Stators zum Rotor
•    Umspülung des Rotors mit Inertgas unter Überdruck

Da üblicherweise brennbare Medien eingesetzt werden, muss auch sichergestellt werden, dass Vorkehrungen zum Explosionsschutz eingehalten werden:

•    Kein heißen Oberflächen - sichere Temperaturbegrenzung
•    Keine Funkenbildung
•    Keine elektrostatischen Ladungen

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen in:

Figur 1a     zeigt eine schematische, nicht maßstabsgetreue Querschnittsdarstellung eines Teils einer erfindungsgemäßen ersten Ausführungsform,

Figur 1b     zeigt eine schematische, nicht maßstabsgetreue Oberansicht eines Teils der erfindungsgemäßen ersten Ausführungsform,

Figur 2a     zeigt eine schematische, nicht maßstabsgetreue Querschnittsdarstellung eines Teils einer erfindungsgemäßen zweiten Ausführungsform,

Figur 2b     zeigt eine schematische, nicht maßstabsgetreue Oberansicht eines Teils der erfindungsgemäßen zweiten Ausführungsform,

Figur 3a     zeigt eine schematische, nicht maßstabsgetreue Querschnittsdarstellung eines Teils einer erfindungsgemäßen dritten Ausführungsform,

Figur 3b     zeigt eine schematische, nicht maßstabsgetreue Oberansicht eines Teils der erfindungsgemäßen dritten Ausführungsform,

Figur 4a     zeigt eine schematische, nicht maßstabsgetreue Querschnittsdarstellung eines Teils einer anderen erfindungsgemäßen Ausführungsform mit kapazitiver Messung,

Figur 4b     zeigt eine schematische, nicht maßstabsgetreue Querschnittsdarstellung eines Teils einer anderen erfindungsgemäßen Ausführungsform mit Infrarotmessung,

Figur 4c     zeigt eine schematische, nicht maßstabsgetreue Querschnittsdarstellung eines Teils einer anderen erfindungsgemäßen Ausführungsform mit Funkmessung,

Figur 4d     zeigt eine schematische, nicht maßstabsgetreue Querschnittsdarstellung eines Teils einer anderen erfindungsgemäßen Ausführungsform mit Strahlungsvermessung,

Figur 4e     zeigt eine schematische, nicht maßstabsgetreue Querschnittsdarstellung eines Teils einer anderen erfindungsgemäßen Ausführungsform mit Strahlungsvermessung,

Figur 5a     zeigt eine schematische, nicht maßstabsgetreue Querschnittsdarstellung einer anderen erfindungsgemäßen Ausführungsform mit einer Kupplung vor dem Einkuppeln,

Figur 5b     zeigt eine schematische, nicht maßstabsgetreue Querschnittsdarstellung der Kupplung nach dem Einkuppeln und

Figur 6     zeigt eine andere erfindungsgemäße Ausführungsform.

In den Figuren sind gleiche Bauteile oder Bauteile mit der gleichen Funktion mit den gleichen Bezugszeichen gekennzeichnet.

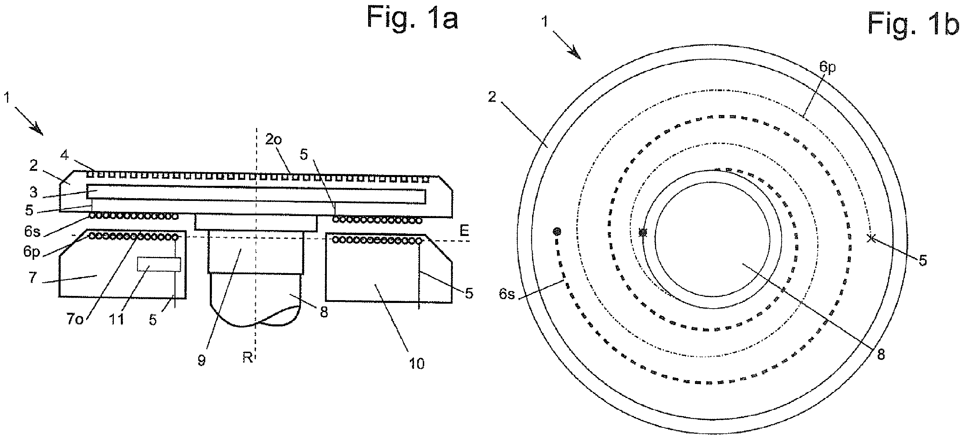

In den nachfolgenden Figuren 1a-3b kann eine Elektronik 11, insbesondere zur Ansteuerung eines Heizers 3, im Primär- und/oder Sekundärstromkreis vorhanden sein. Vorzugsweise wird der Heizer 3 ausschließlich über eine an einer Sekundärwicklung 6s (im Folgenden auch Sekundärspule 6s genannt) induzierten Spannung mit Strom gespeist, während die Regelung der selbigen durch die Elektronik 11 in einem Stator 10 ausschließlich primärseitig erfolgt.

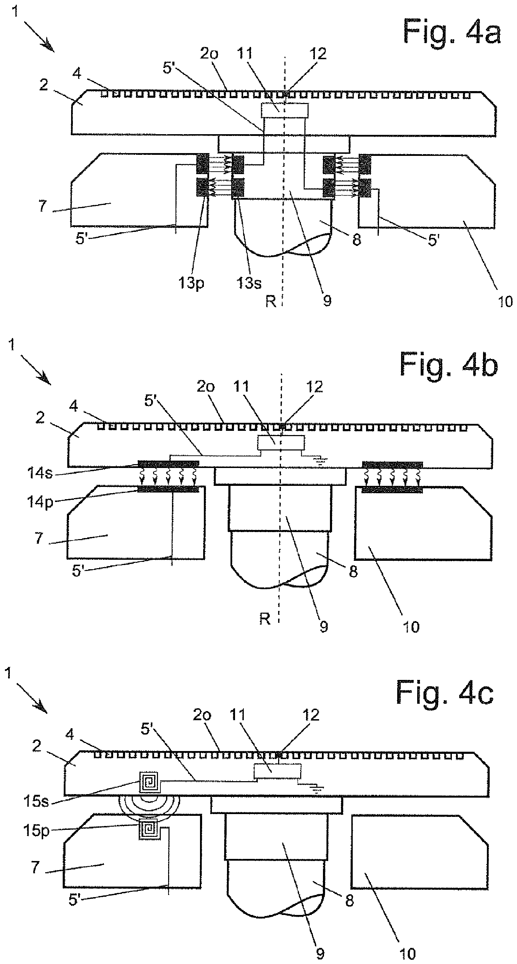

Die Figur 1a zeigt eine schematische, nicht maßstabsgetreue Querschnittsdarstellung einer ersten erfindungsgemäßen Vorrichtung 1. Es werden insbesondere die zur Übertragung der elektrischen Leistung notwendigen Bauteile dargestellt, während die Bauteile zur Messung einer Temperatur in den Figuren 4a-4c gezeigt werden.

Die Vorrichtung 1 besteht aus einem Rotor 9 mit einer Drehwelle 8 (im Folgenden auch Welle 8 genannt) mit einer Rotationsachse R und einem Stator 10.

Im Stator 10 wurde eine Primärwicklung 6p (im Folgenden auch Primärspule 6p genannt) eingebaut. Bei der Primärwicklung 6p handelt es sich insbesondere um eine Flachspule. Die Primärwicklung 6p kann entweder an einer Sockeloberfläche 7o eines Sockels 7, oder, wie in der Figur dargestellt, im Sockel 7 verbaut sein.

Die Primärwicklung 6p wird über Leitungen 5 von Strom, insbesondere Wechselstrom, durchflossen. Erfindungsgemäß wird durch das so erzeugte magnetische Wechselfeld in der Sekundärspule 6s eine Spannung induziert. Die induzierte Spannung erlaubt die Erzeugung eines Stroms, der durch den Heizer 3 fließt und die Erwärmung eines Probenhalters 2 mit einer Probenhalteroberfläche 2o und Fixierelementen 4, insbesondere aber eines fixierten Substrats, erlaubt. Der Vollständigkeit halber wird darauf hingewiesen, dass eine Flachspule, insbesondere die Primärwicklung 6p, keine radialsymmetrische Geometrie bezüglich einer Achse A besitzt, die normal auf einer Ebene E steht, in der sich die Flachspule befindet. Daher wird auch ein durch einen Gleichstrom erzeugtes statisches magnetisches Feld nicht radialsymmetrisch sein. Entsprechend dem Faraday'schen Induktionsgesetz müsste daher in einer sich in dem nichtsymmetrischen Magnetfeld drehenden Leiterschleife, insbesondere der sich drehenden Sekundärwicklung 6s die auch als Flachspule ausgelegt ist, eine Spannung induziert werden. Dennoch ist eine induktive Kopplung durch ein magnetisches Wechselfeld hervorgerufen durch einen Wechselstrom aus steuerungstechnischen und anderen physikalischen Gründen vorzuziehen. Insbesondere ist die induzierte Spannung immer direkt proportional zur zeitlichen Änderung des magnetischen Flusses. Je hochfrequenter daher der angelegte Wechselstrom ist, desto schneller ändert sich der magnetische Fluss und desto höher ist die induzierte Spannung.

Die Figur 1b zeigt eine schematische, nicht maßstabsgetreue Oberansicht der Vorrichtung 1 mit der Primärspule 6p und der Sekundärspule 6s. Beide Spulen 6p, 6s sind als Flachspulen, insbesondere Spiralspulen, noch bevorzugter archimedische Spulen, ausgeführt. Die archimedischen Spiralen gehorchen dem mathematischen Zusammenhang

$$r(\phi) = a * \phi$$

wobei $r(\phi)$ der Radius an der Winkelposition $\phi$ und a eine Konstante ist. Je kleiner die Konstante a, desto kleiner der Abstand zwischen den Spiralarmen. Der Abstand zwischen zwei Spiralarmen einer archimedischen Spirale entlang eines vom Koordinatenursprung ausgehenden Strahls beträgt immer $2\pi a$. Der Übersichtlichkeit halber werden die beiden Flachspulen 6p und 6s in der Figur 1b mit einer größeren Konstanten a dargestellt als in der Figur 1a.

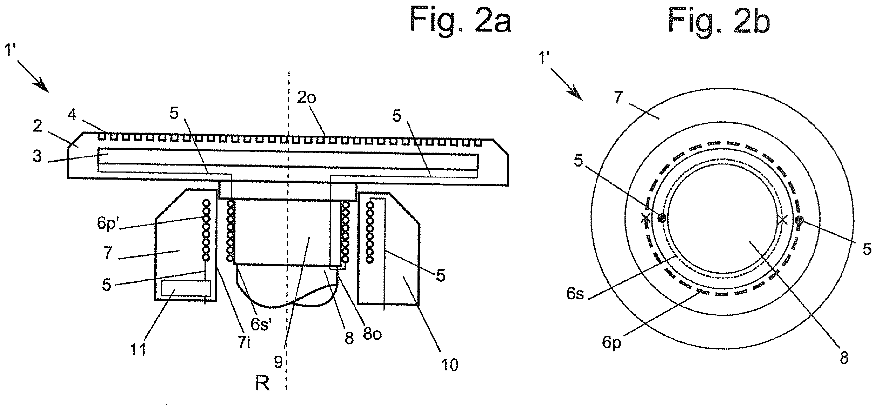

Die Figur 2a zeigt eine schematische, nicht maßstabsgetreue Querschnittsdarstellung einer zweiten erfindungsgemäßen Vorrichtung 1'.

Es werden insbesondere die zur Übertragung der elektrischen Leistung notwendigen Bauteile dargestellt, während die Bauteile zur Messung der Temperatur in den Figuren 4a-4c gezeigt werden.

Die erfindungsgemäße Vorrichtung 1' besteht aus einem Rotor 9 und einem Stator 10. Bei einer Primärwicklung 6p' und einer Sekundärwicklung 6s' handelt es sich um zueinander konzentrisch angeordnete Zylinderspulen. Die Primärwicklung 6p' kann entweder an einer Sockelinnenfläche 7i des Sockels 7, oder, wie in der Figur 2a dargestellt, im Sockel 7 verbaut sein. Die Primärwicklung 6p' wird über die Leitungen 5 von Wechselstrom durchflossen. Die Sekundärwicklung 6s' kann sich, wie in der Figur 2a dargestellt, an einer Wellenoberfläche 8o oder in der Welle 8 befinden.

Die Figur 2b zeigt eine schematische nicht maßstabsgetreue Oberansicht der Vorrichtung 1' mit der Primärspule 6p' und der Sekundärspule 6s'. Beide Spulen 6p' und 6s' sind als Zylinderspulen ausgeführt. Erkennbar ist die konzentrische Lage der Primärspule 6p' und der Sekundärspule 6s' zur Rotationsachse R.

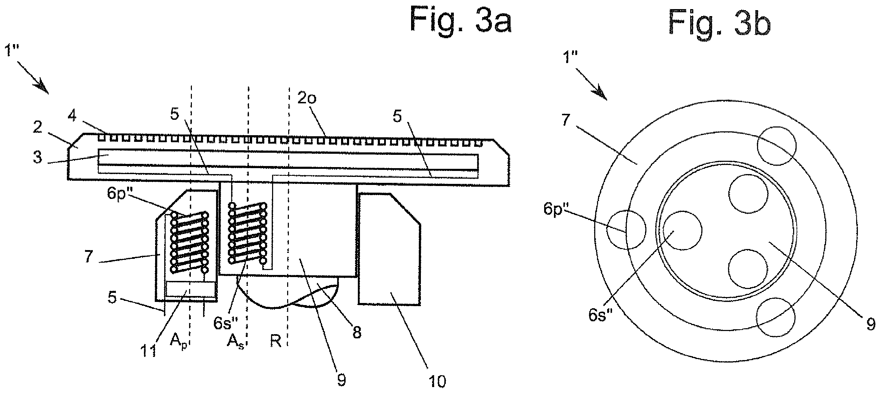

Die Figur 3a zeigt eine schematische, nicht maßstabsgetreue Querschnittsdarstellung einer dritten erfindungsgemäßen Vorrichtung 1".

Es werden insbesondere die zur Übertragung der elektrischen Leistung notwendigen Bauteile, dargestellt, während die Bauteile zur Messung der Temperatur in den Figuren 4a-4c gezeigt werden.

In der erfindungsgemäßen Vorrichtung 1" befindet sich mindestens eine Primärwicklung 6p" im Stator 10 und mindestens eine Sekundärwicklung 6s" im Rotor 9.

Eine Symmetrieachse Ap der Primärwicklung 6p" und eine Symmetrieachse As der Sekundärwicklung 6s" sind nicht deckungsgleich angeordnet. Sie sind azentrisch in Bezug zur Rotationsachse R angeordnet. Insbesondere können mehrere derartige Primärwicklungen 6p" im Stator 10 und/oder mehrere Sekundärwicklung 6s" im Rotor 9 positioniert sein. Die Primärwicklungen 6p" und/oder die Sekundärwicklung 6s' können symmetrisch oder asymmetrisch im Stator 10 bzw. im Rotor 9 positioniert werden. Die Symmetrieachsen Ap und/oder As können einen beliebigen Winkel zur Rotationsachse R einnehmen. Vorzugsweise sind die Symmetrieachsen Ap und/oder As allerdings parallel zur Rotationsachse R.

Die Figur 3b zeigt eine schematische, nicht maßstabsgetreue Schnittansicht, in der jeweils drei, im Winkelabstand von 120° zueinander angeordnete, Primärwicklungen 6p" im Stator 10 und drei, im Winkelabstand von 120° zueinander angeordnete, Sekundärwicklungen 6s" im Rotor 9, erkennbar sind.

Die Figuren 1a-3a zeigen gleichzeitig auch alle notwendigen Bauteile, um eine erste erfindungsgemäße Mess- und Datenübertragungseinrichtung (im Folgenden auch Messsystem genannt) zu konstruieren, bei dem die induktive Kopplung verwendet werden kann, um z.B.

über eine Impedanzmessung die Temperatur des Heizers 3 zu ermitteln. Dem Fachmann auf dem Gebiet ist klar, dass sich bei einer Temperaturerhöhung des Heizers die sekundärseitige Impedanz ändert. Durch die induktive Kopplung ändert sich dann allerdings auch die primärseitige Impedanz, die durch Messung der Spannung und des Stroms leicht ermittelt werden kann, wie weiter oben im Text bereits beschrieben. Damit erhält man durch die primärseitige Impedanzvermessung eine Möglichkeit, die Temperatur sekundärseitig zu bestimmen. Vorzugsweise wird die primärseitige Impedanz bzw. Impedanzänderung mit der vermessenen sekundärseitigen Temperatur bzw. Temperaturänderung kalibriert. Damit erhält man für jeden Impedanzwert bzw. Impedanzänderung eine zugeordnete Temperatur bzw. Temperaturänderung.

Die Figur 4a zeigt eine schematische, nicht maßstabsgetreue Querschnittsdarstellung einer anderen erfindungsgemäßen Vorrichtung 1, bei der ein zweites erfindungsgemäßes Messsystem dargestellt wird. Die Bauteile der erfindungsgemäßen Leistungsübertragung gemäß den Figuren la-3c wurden der Übersichtlichkeit halber nicht eingezeichnet.

Im Probenhalter 2 befindet sich eine Elektronik 11 zur Ansteuerung mindestens eines Thermoelements 12. Erfindungsgemäß können mehrere Thermoelement 12 vorhanden sein. Das Thermoelement 12 wird vorzugsweise an der Probenhalteroberfläche 2o des Probenhalters 2 angebracht, um die Temperatur eines fixierten Substrats vermessen zu können. In speziellen Ausführungsformen kann sich das Thermoelement 12 auch im Probenhalter 2 befinden. Denkbar ist auch eine Kombination von Thermoelementen 12, die im Probenhalter 2 und auf der Probenhalteroberfläche 2o verbaut wurden.

Die Elektronik 11 ist Teil eines über primärseitige Kondensatorteile 13p und sekundärseitige Kondensatorteile 13s und Leitungen 5' geschlossenen Stromkreises. Bei den primärseitigen Kondensatorteilen 13p und sekundärseitigen Kondensatorteilen 13s handelt es sich vorzugsweise um vollumfänglich geschlossene Ringe. Denkbar wäre auch die Verwendung von primärseitigen Ringsegmenten 13p und/oder sekundärseitigen Ringsegmenten 13s. Sollte es sich bei dem primärseitigen Kondensatorteil 13p und dem sekundärseitigen Kondensatorteil 13s um Ringsegmente handeln, so wird der Stromkreis immer nur nach einer vollen Umdrehung kurzzeitig geschlossen.

Die Figur 4b zeigt eine schematische, nicht maßstabsgetreue Querschnittsdarstellung einer anderen erfindungsgemäßen Vorrichtung 1, bei der ein drittes erfindungsgemäßes Messsystem dargestellt wird. Die Bauteile der erfindungsgemäßen Leistungsübertragung gemäß den Figuren 1a-3c wurden der Übersichtlichkeit halber nicht eingezeichnet.

Im Probenhalter 2 befindet sich eine Elektronik 11 zur Ansteuerung mindestens eines Thermoelements 12. Erfindungsgemäß können mehrere Thermoelemente 12 vorhanden sein. Das Thermoelement 12 wird vorzugsweise an der Probenhalteroberfläche 2o des Probenhalters 2 angebracht, um die Temperatur eines fixierten Substrats vermessen zu können. In speziellen Ausführungsformen kann sich das Thermoelement 12 auch im Probenhalter 2 befinden. Denkbar ist auch eine Kombination von Thermoelementen 12, die im Probenhalter 2 und auf der Probenhalteroberfläche 2o verbaut wurden.

Die Elektronik 11 ist Teil eines über primärseitige Infrarotempfänger 14p und sekundärseitige Infrarotsender 14s geschlossenen Stromkreises. Infrarotsender 14p und Infrarotempfänger 14s stellen dabei einen Optokoppler dar. Die Infrarotsender 14p und Infrarotempfänger 14s werden vorzugsweise ringförmig ausgebildet.

Die Figur 4c zeigt eine schematische, nicht maßstabsgetreue Querschnittsdarstellung einer anderen erfindungsgemäßen Vorrichtung 1, bei der ein viertes erfindungsgemäßes Messsystem dargestellt wird. Die Bauteile der erfindungsgemäßen Leistungsübertragung gemäß den Figuren 1a-3c wurden der Übersichtlichkeit halber nicht eingezeichnet.

Im Probenhalter 2 befindet sich eine Elektronik 11 zur Ansteuerung mindestens eines Thermoelements 12. Erfindungsgemäß können mehrere Thermoelemente 12 vorhanden sein. Das Thermoelement 12 wird vorzugsweise an der Probenhalteroberfläche 2o des Probenhalters 2 angebracht, um die Temperatur eines fixierten Substrats vermessen zu können. In speziellen Ausführungsformen kann sich das Thermoelement 12 auch im Probenhalter 2 befinden. Denkbar ist auch eine Kombination von Thermoelementen 12, die im Probenhalter 2 und auf der Probenhalteroberfläche 2o verbaut wurden.

Die Elektronik 11 ist Teil eines über primärseitige Funkempfänger 15p und sekundärseitige Funksender 15s geschlossenen Stromkreises. Der sekundärseitige Funksender 15s muss sich nicht notwendigerweise im Stator 10 befinden, sondern kann sich irgendwo in Reichweite des Funksenders 15s, insbesondere in einem Computer, befinden.

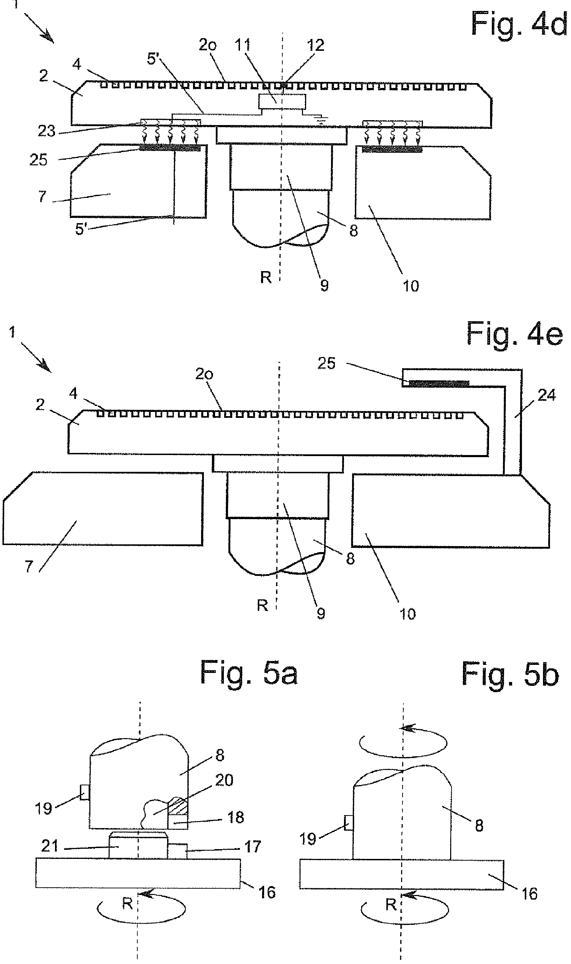

Die Figur 4d zeigt eine schematische, nicht maßstabsgetreue Querschnittsdarstellung einer anderen erfindungsgemäßen Vorrichtung 1, bei der ein fünftes erfindungsgemäßes Messsystem dargestellt wird. Die Bauteile der erfindungsgemäßen Leistungsübertragung gemäß den Figuren 1a-3c wurden der Übersichtlichkeit halber nicht eingezeichnet. Das erfindungsgemäße Messsystem erlaubt die Ermittlung der Temperatur des Probenhalters 2 über die Strahlungsleistung. Gemäß erwähnten erfindungsgemäßen Ausführungsformen ist die Substrathalterung 2 an der Unterseite und/oder dem Rand thermisch isoliert. Gemäß der vorliegenden erfindungsgemäßen Ausführungsform befindet sich an der Unterseite der Substrathalterung 2 ein infrarottransparentes Fenster 23, über das Strahlung, insbesondere Infrarotstrahlung, die Substrathalterung 2 verlassen kann. Ein Detektor 25 kann die so emittierte Strahlung vermessen und aus der Strahlungskurve bzw. Strahlungsleistung auf die Temperatur des Probenhalters 2 zurückrechnen. Bei dem Detektor 25 handelt es sich bevorzugt um einen Infrarotdetektor. Denkbar sind aber auch Detektoren, die eine Strahlungsleistung über ein breiteres Frequenzband als das Infrarotband vermessen können.

Die Figur 4e zeigt eine schematische, nicht maßstabsgetreue Querschnittsdarstellung einer anderen erfindungsgemäßen Vorrichtung 1, bei der ein sechstes erfindungsgemäßes Messsystem dargestellt wird. Die Bauteile der erfindungsgemäßen Leistungsübertragung gemäß den Figuren 1a-3c wurden der Übersichtlichkeit halber nicht eingezeichnet. Das erfindungsgemäße Messsystem verfügt über einen Detektorarm 24, an dem ein Detektor 25 montiert ist, der die Oberfläche des Substratprobenhalters 2, insbesondere aber die Oberfläche eines aufliegenden Substrats (nicht eingezeichnet), vermessen kann. Bei dem Detektor 25 handelt es sich bevorzugt um einen Infrarotdetektor. Denkbar sind aber auch Detektoren, die eine Strahlungsleistung über ein breiteres Frequenzband als das Infrarotband vermessen können.

Die Figur 5a zeigt den unteren Teil einer Drehwelle 8 eines Rotors 9 mit einer Bohrung 20 und einer Nut 18 oberhalb einer Antriebswelle 16 mit Mitnehmer 17 und Zapfen 21 vor der Kupplung. Am Rand der Welle 8 kann sich ein Identifikationschip 19, insbesondere RFID Chip, befinden, der zur eindeutigen und insbesondere vollautomatischen Identifizierung des Rotors 9 dient. Der Identifikationschip 19 kann auch in der Welle 8 oder in jedem anderen Teil des Rotors 9 verbaut sein. Die Bohrung 20 der Welle 8 setzt so auf den Zapfen 21 einer Antriebswelle 16 auf, dass der Mitnehmer 17 von der Nut 18 umschlossen wird.

Die Figur 5b zeigt den unteren Teil der Welle 8 im gekuppelten Zustand mit der Antriebswelle 16. Die beiden Figuren 5a-5b zeigen nur ein sehr vereinfachtes, exemplarisches Kupplungssystem, das durch gattungsgemäß ähnliche Kupplungssysteme ersetzt werden kann. Vorzugsweise sind die Kupplungssysteme aber immer so ausgestaltet, dass eine vollautomatische Kupplung des Rotors 7 über die Welle 8 mit einer Antriebswelle 16, insbesondere durch einen Roboter, erfolgen kann.

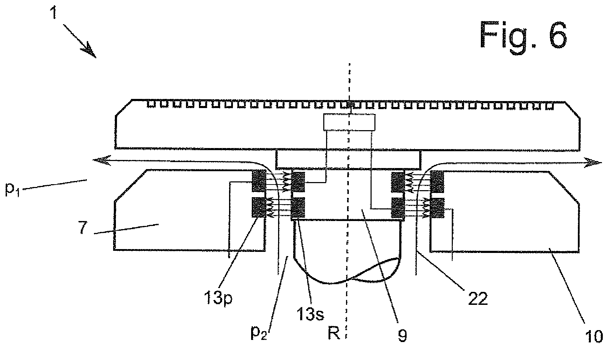

Die Figur 6 zeigt eine andere erfindungsgemäße Vorrichtung 1, bei der ein Gasstrom 22, insbesondere ein Inertgasstrom, den Rotor 9 umspült. Dadurch werden insbesondere alle außen anliegenden elektrischen Bauteile, beispielsweise das primärseitige Kondensatorteil 13p und das sekundärseitige Kondensatorteil 13s umspült und damit geschützt.

Durch das Umspülen derartiger außenliegender stromführender oder Ladung tragender Bauteile mit einem Inertgas 22 wird die Funkenbildung erneut um ein Vielfaches reduziert. Der Hauptgrund der Verwendung eines derartigen Inertgases 22 liegt aber vor allem darin, dass zwischen dem Rotor 9 und dem Stator 10 ein Überdruck p2 aufgebaut wird, der größer ist als der Umgebungsdruck p1. Dadurch wird das Eindringen von möglichen brennbaren Flüssigkeiten, Dämpfen oder Gasen zwischen den Rotor 9 und den Stator 10, erschwert oder sogar vollständig verhindert.

## Bezugszeichenliste

| | |
|---|---|
| 1,1',1" | Vorrichtung |
| 2 | Substrathalterung |
| 2o | Substrathalterungsoberfläche |
| 3 | Heizer |
| 4 | Fixierelemente |
| 5,5' | Leitungen |
| 6p,6p',6p" | Primärwicklungen |
| 6s,6s',6s" | Sekundärwicklungen |
| 7 | Sockel |
| 7o | Sockeloberfläche |
| 7i | Sockelinnenfläche |
| 8 | Drehwelle |
| 8o | Wellenoberfläche |
| 9 | Rotor |
| 10 | Stator |
| 11 | Elektronik |
| 12 | Thermoelement |
| 13p | Primärseitiger Kondensatorteil |
| 13s | Sekundärseitiger Kondensatorteil |
| 14p | Primärseitiger Infrarotempfänger |
| 14s | Sekundärseitiger Infrarotsender |
| 15p | Primärseitiger Funkempfänger |
| 15s | Sekundärseitiger Funksender |
| 16 | Antriebswelle |
| 17 | Mitnehmer |
| 18 | Nut |
| 19 | Identifikationschip |
| 20 | Bohrung |
| 21 | Zapfen |
| 22 | Gasstrom |
| 23 | Infrarotfenster |
| 24 | Detektorarm |
| 25 | Detektor |
| Ap | Primärseitige Symmetrieachse |
| As | Sekundärseitige Symmetrieachse |
| R | Rotationsachse |
| E | Ebene |
| p1, p2 | Druck |

## Patentansprüche

1. Vorrichtung (1,1',1") zur Halterung, Rotation sowie Heizung und/oder Kühlung eines Substrats, insbesondere Wafers, aufweisend:

　　1) einen Rotor (9), aufweisend:

　　　　a) mindestens eine Sekundärwicklung (6s,6s',6s"),
　　　　b) eine Substrathalterung (2) mit einer Substrathalterungsoberfläche (2o) und Fixierelementen (4) zur Fixierung des Substrats,
c) eine Drehwelle (8) zur Rotation der Substrathalterung (2) um eine Rotationsachse (R),
d) mindestens einen elektrischen Heizer (3) zur Heizung und/oder einen Kühler zur Kühlung der Substrathalterungsoberfläche (2o);

2) **dadurch gekennzeichnet, dass** die Vorrichtung einen Stator (10) aufweist mit:

a) mindestens eine Primärwicklung (6p,6p',6p"),
b) einen ringförmigen Sockel (7), wobei die Drehwelle (8) des Rotors (9) zumindest teilweise innerhalb des Sockels (7) angeordnet ist;

und dass die Vorrichtung (1,1',1") derart ausgebil ist, dass durch die mindestens eine Primärwicklung (6p,6p',6p") ein Strom und/oder eine Spannung in der mindestens einen Sekundärwicklung (6s,6s',6s") induzierbar ist, wobei durch den in der mindestens einen Sekundärwicklung (6s,6s',6s") induzierten Strom und/oder Spannung der mindestens eine Heizer (3) und/oder Kühler derart betreibbar ist, dass die Substrathalterungsoberfläche (2o) beheizbar und/oder kühlbar ist.

2. Vorrichtung nach Anspruch 1, wobei die mindestens eine Primärwicklung (6p,6p',6p") an einer Sockeloberfläche (7o,7i) angeordnet ist.

3. Vorrichtung nach Anspruch nach 1 wobei die mindestens eine Primärwicklung (6p,6p',6p") innerhalb des Sockels (7) angeordnet ist.

4. Vorrichtung nach Anspruch 1, wobei die mindestens eine Primärwicklung (6p) und die mindestens eine Sekundärwicklung (6s) als Flachspulen ausgebildet sind, bevorzugt als Spiralspulen, noch bevorzugter als archimedische Spiralspulen.

5. Vorrichtung nach Anspruch 4, wobei die mindestens eine Primärwicklung (6p) und die mindestens eine Sekundärwicklung (6s) parallel zueinander angeordnet sind.

6. Vorrichtung nach Anspruch 4, wobei die die mindestens eine Primärwicklung (6p) und die mindestens eine Sekundärwicklung (6s) in und/oder parallel zu einer Ebene (E) angeordnet sind, wobei die Ebene (E) senkrecht zur Rotationsachse (R) angeordnet ist.

7. Vorrichtung nach Anspruch 4, wobei die mindestens eine Primärwicklung (6p) an einer der Substrathalterung (2) zugewandten Sockeloberfläche (7o) des Sockels (7) angeordnet ist.

8. Vorrichtung nach Anspruch 4, wobei die mindestens eine Sekundärwicklung (6s) an einer dem Sockel (7) zugewandten Rückseite der Substrathalterung (2) angeordnet ist.

9. Vorrichtung nach Anspruch 1, wobei die mindestens eine Primärwicklung (6p',6p") und die mindestens eine Sekundärwicklung (6s',6s") als Zylinderspulen ausgebildet sind.

10. Vorrichtung nach Anspruch 9, wobei die mindestens eine Primärwicklung (6p') und die mindestens eine Sekundärwicklung (6s') konzentrisch zur Rotationsachse (R) angeordnet sind.

11. Vorrichtung nach Anspruch 9, wobei die mindestens eine Primärwicklung (6p') an einer der Drehwelle (8) zugewandten Sockelinnenfläche (7i) des Sockels (7) angeordnet ist und die mindestens eine Sekundärwicklung (6s') an einer der Sockelinnenfläche (7i) zugewandten Wellenoberfläche (8o) der Drehwelle (8) angeordnet ist.

12. Vorrichtung nach Anspruch 9, wobei die mindestens eine Primärwicklung (6p") und die mindestens eine Sekundärwicklung (6s") azentrisch zur Rotationsachse (R) angeordnet sind.

13. Vorrichtung nach Anspruch 9, wobei mindestens zwei Primärwicklungen (6p") innerhalb des Sockels (7) und mindestens zwei Sekundärwicklungen (6s") innerhalb der Drehwelle (8) angeordnet sind.

14. Vorrichtung nach Anspruch 13, wobei die mindestens zwei Primärwicklungen (6p") und die mindestens zwei Sekundärwicklungen (6s") in einem gleichmäßigen Winkelabstand um die Rotationsachse (R) herum angeordnet sind

15. Vorrichtung nach Anspruch 1, aufweisend eine Messeinrichtung zur Messung der Temperatur des Heizers (3), der Substrathalterung (2), der Substrathalterungsoberfläche (2o) und/oder des Substrats, sowie aufweisend eine Einrichtung zur Datenübertragung der gemessenen Temperatur des Heizers (3), der Substrathalterung (2), der Substrathalterungsoberfläche (2o) und/oder des Substrats vom Rotor (9) auf den Stator (10), bevorzugt über die induktive Kopplung zwischen der mindestens einen Primärwicklung (6p,6p',6p") und der mindestens einen Sekundärwicklung (6s,6s',6s").

16. Vorrichtung nach Anspruch 1, der Rotor (9) aufweisend einen Identifikationschip (19), insbesondere RFID Chip, zur eindeutigen, und insbesondere vollautomatischen, Identifizierung des Rotors (9), wobei sich der Identifikationschip (19) bevorzugt am Rand der Drehwelle (8) befindet.

**17.** Vorrichtung nach Anspruch 1, aufweisend Spülmittel zur Umspülung des Rotors (9) durch einen Gasstrom (22).

**18.** Verfahren zur Halterung, Rotierung sowie Heizung und/oder Kühlung eines Substrats, insbesondere Wafers, mit den folgenden Schritten, insbesondere mit einer Vorrichtung nach Anspruch 1 :

- Halterung des Substrats durch einen Rotor (9), aufweisend eine Substrathalterung (2) mit einer Substrathalterungsoberfläche (2o) und Fixierelementen (4) zur Fixierung des Substrats,
- Induktion eines Stromes in mindestens einer Sekundärwicklung (6s,6s',6s") des Rotors (9) durch mindestens eine stromdurchflossene Primärwicklung (6p,6p',6p") eines Stators (10),
- wobei durch den in der mindestens einen Sekundärwicklung (6s,6s',6s") induzierten Strom mindestens ein Heizer (3) und/oder ein Kühler derart betrieben wird, dass die Substrathalterungsoberfläche (2o) und dadurch das Substrat beheizt und/oder gekühlt wird.

**19.** Verfahren nach Anspruch 18, wobei der Rotor (9) durch einen Gasstrom (22), insbesondere einen Inertgasstrom, umspült wird, wobei bevorzugt außen anliegende elektrische Bauteile, insbesondere ein primärseitiges Kondensatorteil (13p) und ein sekundärseitiges Kondensatorteil (13s), umspült werden, wobei bevorzugt zwischen dem Rotor (9) und dem Stator (10) ein Überdruck (p2) aufgebaut wird, der größer ist als ein Umgebungsdruck (p1).

**Claims**

**1.** A device (1, 1', 1") for holding, rotating, heating and/or cooling a substrate, in particular a wafer, with:

1) a rotor (9), having:

a) at least one secondary winding (6s, 6s', 6s"),
b) a substrate holder (2) with a substrate holder surface (2o) and fixing elements (4) for fixing the substrate,
c) a rotary shaft (8) for rotating the substrate holder (2) around a rotary axis (R),
d) at least one electric heater (3) for heating and/or a cooler for cooling the substrate holder surface (2o);

2) **characterized in that** the device (1, 1', 1") comprises a stator (10), having:

a) at least one primary winding (6p, 6p', 6p"),
b) a ring-shaped base (7), wherein the rotary shaft (8) of the rotor (9) is arranged at least partially inside the base (7);

and that the device (1, 1', 1") is designed such that a current and/or a voltage can be induced in the at least one secondary winding (6s, 6s', 6s") by the at least one primary winding (6p, 6p', 6p"), wherein the current and/or voltage induced in the at least one secondary winding (6s, 6s', 6s") can be used to power the at least one heater (3) and/or cooler so that the substrate holder surface (2o) can be heated and/or cooled.

**2.** The device according to claim 1, wherein the at least one primary winding (6p, 6p', 6p") is arranged on a base surface (7o, 7i).

**3.** The device according to claim 1, wherein the at least one primary winding (6p, 6p', 6p") is arranged inside the base (7).

**4.** The device according to claim 1, wherein the at least one primary winding (6p) and the at least one secondary winding (6s) are designed as flat coils, preferably as spiral coils, and even more preferably as Archimedean spiral coils.

**5.** The device according to claim 4, wherein the at least one primary winding (6p) and the at least one secondary winding (6s) are arranged parallel to one another.

**6.** The device according to claim 4, wherein the at least one primary winding (6p) and the at least one secondary winding (6s) are arranged in and/or parallel to a plane (E), wherein the plane (E) is arranged at right angles to the rotary axis (R).

**7.** The device according to claim 4, wherein the at least one primary winding (6p) is arranged on a base surface (7o) of the base (7), facing the substrate holder (2).

**8.** The device according to claim 4, wherein the at least one secondary winding (6s) is arranged on a reverse side of the substrate holder (2), facing the base (7).

**9.** The device according to claim 1, wherein the at least one primary winding (6p', 6p") and the at least one secondary winding (6s', 6s") are designed as cylinder coils.

**10.** The device according to claim 9, wherein the at least one primary winding (6p') and the at least one secondary winding (6s') are arranged concentrically in relation to the rotary axis (R).

11. The device according to claim 9, wherein the at least one primary winding (6p') is arranged on an inner base surface (7i) of the base (7) facing the rotary shaft (8) and the at least one secondary winding (6s') is arranged on a shaft surface (8o) of the rotary shaft (8) facing the inner base surface (7i).

12. The device according to claim 9, wherein the at least one primary winding (6p") and the at least one secondary winding (6s") are arranged acentrically in relation to the rotary axis (R).

13. The device according to claim 9, wherein at least two primary windings (6p") are arranged inside the base (7) and at least two secondary windings (6s") are arranged inside the rotary shaft (8).

14. The device according to claim 13, wherein the at least two primary windings (6p") and the at least two secondary winding (6s") are arranged at an equal angular distance around the rotary axis (R).

15. The device according to claim 1, having a measuring device for measuring the temperature of the heater (3), the substrate holder (2), the substrate holder surface (2o) and/or the substrate, as well as a device for transmitting the temperature measurements for the heater (3), the substrate holder (2), the substrate holder surface (2o) and/or the substrate from the rotor (9) to the stator (10), preferably via the inductive coupling between the at least one primary winding (6p, 6p', 6p") and the at least one secondary winding (6s, 6s', 6s").

16. The device according to claim 1, the rotor (9) having an identification chip (19), in particular an RFID chip, for unequivocal and in particular fully automated identification of the rotor (9), wherein the identification chip (19) is preferably located on the rim of the rotary shaft (8).

17. The device according to claim 1, having a flushing agent for flushing the rotor (9) using a gas flow (22).

18. A method for holding, rotating and heating and/or cooling a substrate, in particular a wafer, with the following steps, in particular with a device according to claim 1:

- holding of the substrate using a rotor (9), comprising a substrate holder (2) with a substrate holder surface (2o) and fixing elements (4) for fixing the substrate,
- induction of a current in at least one secondary winding (6s, 6s', 6s") of the rotor (9) using at least one current-carrying primary winding (6p, 6p', 6p") of a stator (10),
- wherein the current induced in the at least one secondary winding (6s, 6s', 6s") is used to power at least one heater (3) and/or cooler so that the substrate holder surface (2o), and therefore the substrate, are heated and/or cooled.

19. The method according to claim 18, wherein the rotor (9) is flushed by a gas flow (22), in particular an inert gas flow, wherein preferably externally attached electric components, in particular a primary-side capacitor component (13p) and a secondary-side capacitor component (13s), are flushed, wherein an overpressure (p2) is built up preferably between the rotor (9) and the stator (10), which is greater than an ambient pressure (p1).

**Revendications**

1. Dispositif (1, 1', 1''') de fixation, rotation ainsi que de chauffage et/ou refroidissement d'un substrat, en particulier d'une plaquette, présentant :

   1) un rotor (9), présentant ;

   a) au moins un bobinage secondaire (6s, 6s', 6s"),
   b) une fixation de substrat (2) avec une surface de fixation de substrat (2o) et des éléments de fixation (4) pour la fixation du substrat,
   c) un arbre tournant (8) pour la rotation de la fixation de substrat (2) sur un axe de rotation (R),
   d) au moins un filament chauffant (3) électrique pour le chauffage et/ou un radiateur pour refroidir la surface de fixation de substrat (2o) ;

   2) **caractérisé en ce que** le dispositif présente un stator (10) avec

   a) au moins un bobinage primaire (6p, 6p', 6p"),
   b) un socle annulaire (7), dans lequel l'arbre tournant (8) du rotor (9) est agencé au moins partiellement à l'intérieur du socle (7) ;

   et que le dispositif (1, 1', 1''') est ainsi conçu que par l'au moins un bobinage primaire (6p, 6p', 6p"), un courant et/ou une tension peut être induit(e) dans l'au moins un bobinage secondaire (6s, 6s', 6s"), dans lequel par le courant et/ou une tension induit(e) dans l'au moins un bobinage secondaire (6s, 6s', 6s"), l'au moins un filament chauffant (3) et/ou radiateur peu(ven)t être ainsi utilisé(s) que la surface de fixation de substrat (2o) peut être chauffée et/ou refroidie.

2. Dispositif selon la revendication 1, dans lequel l'au moins un bobinage primaire (6p, 6p', 6p") est agencé sur une surface de socle (7o, 7i).

3. Dispositif selon la revendication 1, dans lequel l'au moins un bobinage primaire (6p, 6p', 6p") est agencé à l'intérieur du socle (7).

4. Dispositif selon la revendication 1, dans lequel l'au moins un bobinage primaire (6p) et l'au moins un bobinage secondaire (6s) sont conçus en tant que bobines plates, de préférence en tant que bobines hélicoïdales, plus encore de préférence en tant que bobines hélicoïdales d'Archimède.

5. Dispositif selon la revendication 4, dans lequel l'au moins un bobinage primaire (6p) et l'au moins un bobinage secondaire (6s) sont agencés parallèlement entre eux.

6. Dispositif selon la revendication 4, dans lequel l'au moins un bobinage primaire (6p) et l'au moins un bobinage secondaire (6s) sont agencés dans et/ou parallèlement à un plan (E), dans lequel le plan (E) est agencé verticalement à l'axe de rotation (R).

7. Dispositif selon la revendication 4, dans lequel l'au moins un bobinage primaire (6p) est agencé sur une surface de socle (7o) du socle (7) orientée vers la fixation de substrat (2).

8. Dispositif selon la revendication 4, dans lequel l'au moins un bobinage secondaire (6s) est agencé sur une face arrière de la fixation de substrat (2) orientée vers le socle (7).

9. Dispositif selon la revendication 1, dans lequel l'au moins un bobinage primaire (6p, 6p") et l'au moins un bobinage secondaire (6s, 6s") sont conçus en tant que bobines cylindriques.

10. Dispositif selon la revendication 9, dans lequel l'au moins un bobinage primaire (6p') et l'au moins un bobinage secondaire (6s') sont agencés de manière concentrique par rapport à l'axe de rotation (R).

11. Dispositif selon la revendication 9, dans lequel l'au moins un bobinage primaire (6p') est agencé sur une surface intérieure de socle (7i) du socle (7) orientée vers l'arbre tournant (8) et l'au moins un bobinage secondaire (6s') est agencé sur une surface d'arbre (8o) de l'arbre tournant (8) orientée vers la surface intérieure de socle (7i).

12. Dispositif selon la revendication 9, dans lequel l'au moins un bobinage primaire (6p") et l'au moins un bobinage secondaire (6s") sont agencés de manière acentrique par rapport à un axe de rotation (R).

13. Dispositif selon la revendication 9, dans lequel au moins deux bobinages primaires (6p") sont agencés à l'intérieur du socle (7) et au moins deux bobinages secondaires (6s") sont agencés à l'intérieur de l'arbre tournant (8).

14. Dispositif selon la revendication 13, dans lequel les au moins deux bobinages primaires (6p") et les au moins deux bobinages secondaires (6s") sont agencés dans un écart angulaire égal autour de l'axe de rotation (R).

15. Dispositif selon la revendication 1, présentant un dispositif de mesure pour mesurer la température du filament chauffant (3), de la fixation de substrat (2), de la surface de fixation de substrat (2o) et/ou du substrat, ainsi que présentant un dispositif pour la transmission de données de la température mesurée du filament chauffant (3), de la fixation de substrat (2), de la surface de fixation de substrat (2o) et/ou du substrat du rotor (9) sur le stator (10), de préférence par le biais d'un couplage inductif entre l'au moins un bobinage primaire (6p, 6p', 6p") et l'au moins un bobinage secondaire (6s, 6s', 6s").

16. Dispositif selon la revendication 1, le rotor (9) présentant une puce d'identification (19), en particulier une puce RFID, pour l'identification claire et en particulier entièrement automatique du rotor (9), dans lequel la puce d'identification (19) se trouve de préférence au bord de l'arbre tournant (8).

17. Dispositif selon la revendication 1, présentant des moyens de rinçage pour rincer le rotor (9) par un flux gazeux (22).

18. Procédé de fixation, rotation ainsi que de chauffage et/ou refroidissement d'un substrat, en particulier d'une plaquette, comprenant les étapes suivantes, en particulier un dispositif selon la revendication 1 :

    - fixation du substrat par un rotor (9), présentant une fixation de substrat (2) avec une surface de fixation de substrat (2o) et des éléments de fixation (4) pour la fixation du substrat,
    - induction d'un courant dans au moins un bobinage secondaire (6s, 6s', 6s") du rotor (9) par au moins un bobinage primaire (6p, 6p', 6p") d'un stator (10) traversé par le courant,
    - dans lequel par le courant induit dans l'au moins un bobinage secondaire (6s, 6s', 6s"), au moins un filament chauffant (3) et/ou un radiateur sont ainsi utilisé(s) que la surface de fixation de substrat (2o) et ainsi le substrat, peut être chauffé(e) et/ou refroidi(e).

19. Dispositif selon la revendication 18, dans lequel le rotor (9) est rincé par un flux gazeux (22), en particulier un flux de gaz inerte, dans lequel de préférence, des composants électriques placés à l'extérieur, en particulier une

pièce de condensateur (13p) côté primaire et une pièce de condensateur (13s) côté secondaire sont rincées, dans lequel de préférence une surpression (p2) est développée entre le rotor (9) et le stator (10) qui est plus grande qu'une pression ambiante (pl).

Fig. 1b

Fig. 1a

Fig. 2b

Fig. 2a

Fig. 3b

Fig. 3a

Fig. 4a

Fig. 4b

Fig. 4c

Fig. 4d

Fig. 4e

Fig. 5a

Fig. 5b

Fig. 6

**IN DER BESCHREIBUNG AUFGEFÜHRTE DOKUMENTE**

**In der Beschreibung aufgeführte Patentdokumente**

- JP 2001003127 A
- EP 2741316 A1